# EUROPEAN PATENT SPECIFICATION

(11) **EP 2 792 720 B1**
(45) Date of publication and mention of the grant of the patent: **01.04.2020**
(21) Application number: 14164722.2
(22) Date of filing: 15.04.2014
(51) Int. Cl.: C09D 7/61, H01L 23/373, H01S 5/024, C09D 1/00, C08K 7/24, C08K 3/04, C08K 3/20

(54) **Method of a thermal resistance reduction in electronic power devices, especially in laser diodes**
Verfahren zur Wärmewiderstandsreduzierung in Reduktion in elektronischen Leistungsvorrichtungen, insbesondere in Laserdioden
Procédé de réduction de la résistance thermique dans des dispositifs électroniques de puissance, en particulier dans des diodes laser

(30) Priority: 15.04.2013 PL 40355013
(43) Date of publication of application: 22.10.2014
(73) Proprietor: Siec Badawcza Lukasiewicz- Instytut Technologii Materialow Elektronicznych, 01-919 Warszawa (PL)
(72) Inventor: Dabrowska - Tumanska, Elzbieta, 01-494 Warszawa (PL); Teodorczyk, Marian, 01-926 Warszawa (PL); Lipinska, Ludwika, 04-346 Warszawa (PL); Malag, Andrzej, 01-227 Warszawa (PL); Wilinski, Zbigniew, 01-405 Warszawa (PL)
(74) Representative: AOMB Polska Sp. z.o.o.

(56) References cited:
- US-A1- 2012 077 040
- J. LIU ET AL: "Graphene oxide absorber for 2 m passive mode-locking Tm:YAlO3 laser", LASER PHYSICS LETTERS, vol. 9, no. 1, 2 January 2012 (2012-01-02) , pages 15-19, XP055201130, ISSN: 1612-2011, DOI: 10.1002/lapl.201110087
- R. KOZINSKI ET AL: "Application of graphene oxide for reduction of thermal resistance of high-power laser diodes", ELECTRONICS LETTERS, vol. 49, no. 24, 21 November 2013 (2013-11-21), pages 1550-1551, XP055201144, ISSN: 0013-5194, DOI: 10.1049/el.2013.3273

## Description

The object of the invention is a method of a thermal resistance reduction in electronic power devices, especially in laser diodes. The invention relates to manufacturing technology of electronic power devices, especially laser diodes of medium and high optical power.

In semiconductor power devices, which include laser diodes, power diodes, transistors, thyristors, triacs, part of the energy generated in an active area is converted into heat during their operation. This heat is removed by coolers - radiators. During operation of the semiconductor laser, the rate of heat dissipation from the active area is a critical characteristic responsible for its parameters and lifetime. Semiconductor structures, so-called chips, are attached to the coolers by soldering method, mostly using metal eutectic solders. Laser diodes of medium and high optical power, among others, are attached in this manner.

Such a soldering introduces compressive mounting stresses due to differences in thermal expansion coefficients (CTE) of copper (Cu - 16.5 [10⁻⁶/K]) and gallium arsenide (GaAs - about 6[10⁻⁶/K]). In part, these problems have been alleviated by the use of spacers ("heat-spreaders") of CuC composite, having their coefficient of thermal expansion adjusted to GaAs - a base material of the heterostructure of semiconductor lasers emitting in the wavelength range of 630 nm to 1 µm and having a high thermal conductivity.

There is still a problem of dissipating the heat flux directed from the active area and substrate to the n-contact. Convection and heat removal by aluminium wires are processes of a very low efficiency. There is a possibility of additional heat dissipation from the sides of the chip and the sides of the spacer.

The authors of the present invention provide a method of deposition of graphene oxide layers on coolers and spacers additionally dissipating heat in electronic power devices, especially in laser diodes. For this purpose, during the mounting of the device, suitable suspension of graphene oxide at a concentration of 1mg/ml was used. Graphene oxide contains, in its structure, numerous oxygenated groups, such as hydroxyl, epoxy, carboxyl groups. Their presence prevents the free movement of charges, so it is a good electrical insulator and at the same time a very good heat conductor. The layer was dried in air for several hours.

According to the invention, the method of the thermal resistance reduction in electronic power devices, especially in laser diodes, is characterised in that it comprises the steps of:
a) deposition to the said electronic power device, and especially to the cooler of the semiconductor laser, a stable aqueous suspension of graphene oxide, in particular at a concentration of 1mg/ml,
b) drying the obtained layer at room temperature in air for a time of 1 to 10 hours.

Preferably, the content of graphene oxide nanoplatelets in the said suspension is 1 wt.%.

Preferably, in step a), the suspension is deposited with a technique selected from: painting with a brush or a dispenser, or another applicator allowing precise application of small amounts (about 1 mm³) of liquids.

### Detailed Description of the Invention

Now, the invention will be presented in greater detail in preferred embodiments, with reference to the accompanying drawings in which:
- Fig. 1: shows a SEM image of graphene oxide layer deposited on a silicon wafer at high magnification with visible structure consisting of single platelets,
- fig. 2: shows a characteristic XPS spectrum of graphene oxide layer deposited on a silicon wafer,
- fig. 3: shows a characteristic Raman spectrum of reduced graphene oxide,

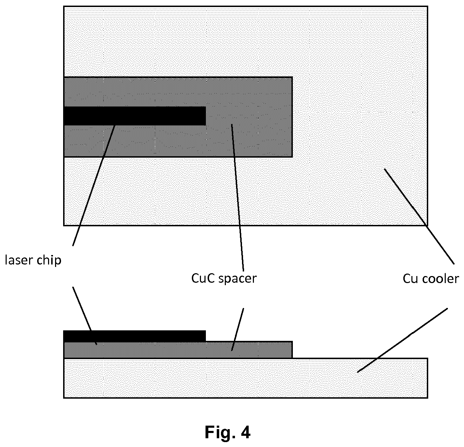

- fig. 4: shows a scheme of a laser diode with a traditional heat-spreader in the form of a plate, soldered with a solder,
- fig. 5: shows normalized spectral (at different currents) characteristics of the laser diode before and after the use of graphene oxide,
- fig. 6: shows voltage-current (U) and light-current (P) characteristics for the laser diode before and after the deposition of graphene oxide - the characteristics overlap, and
- fig. 7: shows images of the laser diode mounted using a traditional CuC heat-spreader and a diagram of depositing graphene oxide suspension to the radiator of the laser diode.

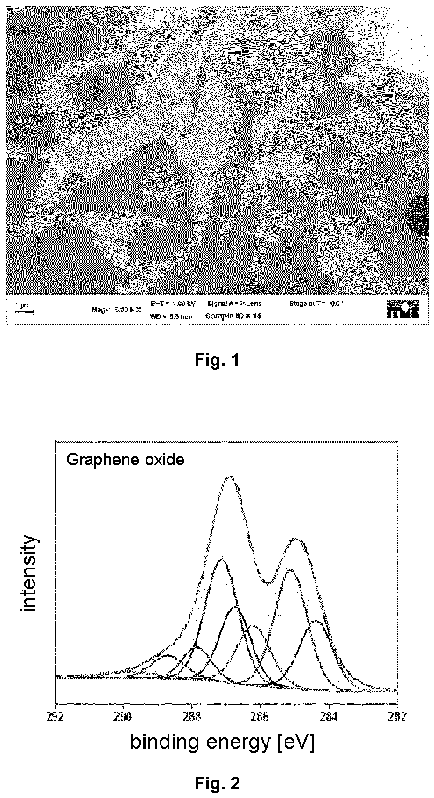

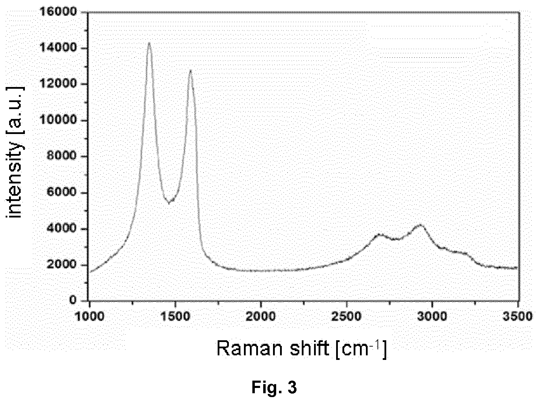

The suspension of graphene oxide was prepared in the following manner:
To produce graphite oxide, the modified Hummers method was used. To 200 ml of concentrated sulfuric acid (POCh, 96-98%, p.a.), 5 g of thermally expanded flake graphite (Asbury Carbons, flake size: 300-425 µm) and 6.5 g of potassium nitrate (V) (POCh, pur.) were introduced. After cooling the mixture to a temperature below 5°C in an ice bath, 15 g of potassium permanganate (VII) (POCh, pur.) was added in small portions. After pouring in the last portion, the beaker reaction was moved to a bath with a temperature of 25°C allowed to stand for 16h. The beaker was placed in the ice bath again, and 230 ml of deionized water was slowly added. The mixture was heated to 95°C and was maintained in this state for 15 minutes. Then, 280 ml of deionized water was poured in, cooled to room temperature and 5 ml of 30% hydrogen peroxide (Chempur, pur.) was added dropwise. The suspension of graphite oxide was repeatedly washed with deionized water and with 3% solution of hydrochloric acid to remove manganese and sulphate ions remaining after the reaction. The aqueous suspension of graphite oxide was then sonicated for 1h in an ultrasonic homogeniser. This measure attempts to induce exfoliation of oxidised carbon planes in graphite, which results in stable suspension of graphene oxide. Properties of this suspension are illustrated in Figs 1-3.

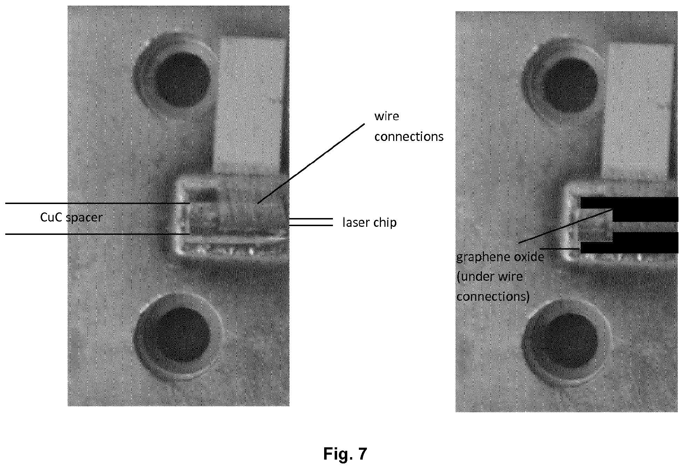

The suspension of graphene oxide was precisely deposited with a brush to the laser coolers according to a diagram shown in Fig. 7.

The deposited suspension was dried in air, at room temperature, for a time of 1 to 10 hours.

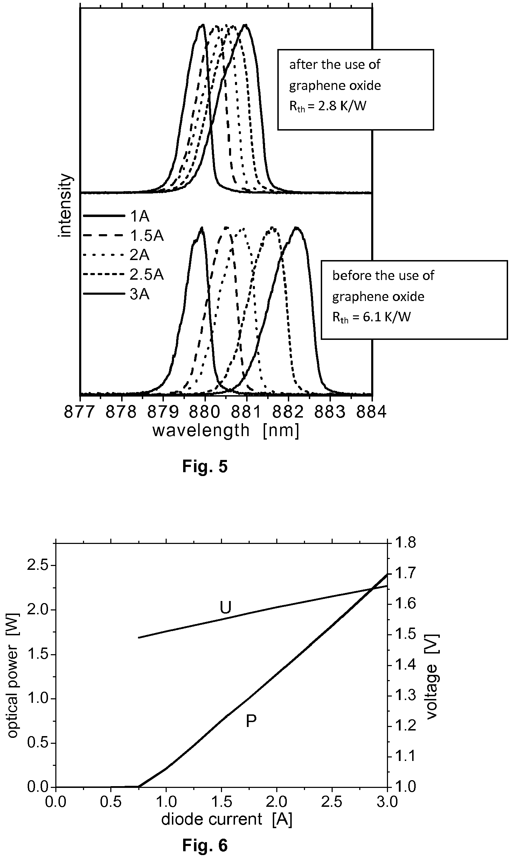

Effectiveness of heat dissipation was checked by comparing the measurements of shifts of spectral characteristics with increasing current for laser diodes before and after the deposition of graphene oxide. Thermal resistance (Rₜₕ) - a parameter relating to the effectiveness of heat dissipation from the active area - decreased more than twice. The light-current and voltage-current characteristics have not changed. The results are shown in Figs 5 and 6.

### Conclusions

By using graphene oxide, it was possible to further reduce the temperature of the active area by a few degrees (e.g. for a 880 nm laser diode with a 180 µm active strip and a length of 3 mm when operating at a current of 2 A, the junction temperature is reduced by about 6°C, when operating at a current of 3 A - by about 9°C). This increases the performance and lifetime of the laser diode.

## Claims

1. A method of a thermal resistance reduction in electronic power devices, especially in laser diodes, **characterised in that** it comprises the steps of:
a) depositing a stable aqueous suspension of graphene oxide, in particular at a concentration of 1 mg/ml, on coolers and spacers additionally dissipating heat in the electronic power devices, especially on a cooler of a semiconductor laser,
b) drying the obtained layer at room temperature in air for a period from 1 to 10 hours.

2. The method according to claim 1, **characterised in that** the content of graphene oxide nanoplatelets in the said suspension is 1 wt.%.

3. The method according to claim 1 or 2, **characterised in that** in step a), the suspension is deposited with a technique selected from: painting with a brush or a dispenser, or another applicator allowing precise deposition of small amounts of liquids.

## Patentansprüche

1. Verfahren zur Reduzierung des Wärmewiderstands in elektronischen Leistungsbauelementen, insbesondere in Laserdioden, **dadurch gekennzeichnet, dass** es die folgenden Schritte umfasst:
a) Ablagerung einer stabilen wässrigen Suspension von Graphenoxid, insbesondere in einer Konzentration von 1 mg/ml, auf Kühlern und Abstandshaltern, die zusätzlich Wärme in die elektronischen Leistungsgeräte ableiten, insbesondere auf einen Kühler eines Halbleiterlasers,
b) Trocknen der erhaltenen Schicht bei Raumtemperatur in Luft für eine Zeit von 1 bis 10 Stunden.

2. Verfahren nach Anspruch 1, **dadurch gekennzeichnet, dass** der Gehalt an Graphenoxid-Nanoplättchen in der Suspension 1 Gew.-% beträgt.

3. Verfahren nach Anspruch 1 oder 2, **dadurch gekennzeichnet, dass** in Schritt a) wird die Suspension mit einer Technik aufgetragen, die ausgewählt ist aus: Streichen mit einem Pinsel oder einem Spender oder einem anderen Applikator, der eine präzise Auftragen kleiner Mengen von Flüssigkeiten ermöglicht.

## Revendications

1. Procédé de réduction de la résistance thermique dans les dispositifs électroniques de puissance, notamment dans les diodes laser, **caractérisé en ce que** il comprend les étapes de:
a) déposer une suspension aqueuse stable d'oxyde de graphène, en particulier à une concentration de 1 mg/ml, sur des refroidisseurs et des entretoises dissipant en outre la chaleur dans les dispositifs électroniques de puissance, notamment sur un refroidisseur d'un laser semi-conducteur
b) sécher la couche obtenue à température ambiante dans l'air pendant une durée de 1 à 10 heures.

2. Procédé selon la revendication 1, **caractérisé en ce que** la teneur en nanoplaquettes d'oxyde de graphène dans ladite suspension est de 1% en poids.

3. Procédé selon la revendication 1 ou 2, **caractérisé en ce que** à l'étape a), la suspension est déposée avec une technique choisie parmi: la peinture au pinceau ou au distributeur, ou un autre applicateur permettant un dépôt précis de petites quantités de liquides.
